# EUROPEAN PATENT APPLICATION

(11) **EP 3 595 147 A1**
(43) Date of publication of application: **15.01.2020**
(21) Application number: 18183107.4
(22) Date of filing: 12.07.2018
(51) Int. Cl.: H02K 15/00, H02K 11/20, G01H 3/04, H02K 1/18

(54) **STRUCTURE HEALTH MONITORING OF THE STATOR OF AN ELECTRICAL GENERATOR**

(71) Applicant: Siemens Gamesa Renewable Energy A/S, 7330 Brande (DK)
(72) Inventor: Corbetta, Matteo, Los Altos, 94024 (US); Dessein, Arnaud, 8600 Silkeborg (DK)
(74) Representative: Aspacher, Karl-Georg

(57) **Abstract**

A stator (20) for an electrical generator (11) including a stator body (40) comprises:
- a support structure (50),
- a lamination stack (60) supported by the support structure (50),
- at least one welding (80),
wherein the stator body (40) further comprised a monitoring device (100) for monitoring the at least one weld (80), the monitoring device (100) comprising at least one sensor (101, 102, 103) for measuring the dynamic deformation of the stator body (40).

## Description

### Field of invention

The present invention relates to the monitoring of the structure health of the stator in an electrical generator, e.g. a segmented stator in a direct drive electrical generator for a wind power turbine.

### Art Background

An electrical generator, such as an electric generator installed in a wind turbine, typically comprises a rotor which rotates relative to a stator.

The stator normally comprises a frame body longitudinally extending along a longitudinal axis and including a plurality of teeth protruding according to a radial direction from the stator yoke. In the stator a plurality of slots are also defined, each slot being delimited circumferentially by two adjacent teeth. Each slot houses a respective winding.

Lamination sheets are attached one after another along the axial direction of the stator and form a lamination stack of the stator.

In this technical field, it is further known to build direct drive electrical generators, in particular large direct drive electrical generators to be used in a wind power turbine, including a stator having a segmented structure. The stator segments may be arranged to cover for example an arc of 30, 60, 90, 120 degrees (or any other angle) along the circumferential direction of the stator. The stator segments are circumferentially joined together to form the stator (for example a stator may comprise six stator segments, each covering an arc of 60 degrees). In order to allow the joining of the segments, each segment comprises two respective flat bars at the respective circumferential ends. Each flat bar comprises a plurality of holes for a respective plurality of bolts. Adjacent flat bars belonging to different adjacent segments are bolted together in order to fix such adjacent segments to each other.

The flat bars are elements of a support structure of each segment to which a respective lamination stack is welded. Each support structure comprises two flat bars and a plurality of beams to which the respective lamination stack is welded. In particular, in each segment a respective lamination stack is welded, at the respective circumferential ends, to the flat bars.

The welding between the lamination stack and the flat bars are particularly critical and need to be monitored to avoid serious inconveniences: if the welds connecting the laminated steel and a flat bar is lost, the segment end can deform and approach the rotor. If the windings touch the rotor, the damage is such that it is likely that the generator will have to be replaced.

One know solution to avoid such inconveniences is that of visually inspecting the welding, which however is not an optimal solution in terms of efficiency and precision of the results. For example, a visual inspecting of the welding can identify a damage, for example a crack in the welding, only when such damage has reached a visible scale.

Therefore, there is still a need to provide an optimized system and a method for monitoring the structure health of the stator in an electrical generator, in particular by monitoring the welds comprised in the stator.

### Summary of the invention

This need may be met by the subject matter according to the independent claims. Advantageous embodiments of the present invention are described by the dependent claims.

According to an aspect of the present invention, it is provided a stator for an electrical generator including a stator body comprising:
- a support structure,
- a lamination stack supported by the support structure,
- at least one weld,
wherein the stator body further comprised a monitoring device for monitoring the at least one weld, the monitoring device comprising at least one sensor for measuring the dynamic deformation of the stator body.

The above describe stator may be conveniently integrated in an electrical generator for a wind turbine.

Particularly, but not exclusively, such electrical generator may be a direct drive electrical generator.

According to embodiments of the invention, the lamination stack is fixed to the support structure by means of said at least one weld.

In embodiments wherein the stator comprises a plurality of segments joined together at respective circumferential ends, said at least one weld is provided at one respective circumferential end. In particular, for each segment the support structure may comprises two flat bars at the respective circumferential ends for joining together the plurality of segments, said at least one weld being provided at one or both the flat bars.

According to other embodiment of the present invention, the stator is not segments and comprises a single solid stator body where the at least one weld to be monitored through the monitoring device is provided.

According to embodiments of the invention, the support structure comprises at least a plurality of axially oriented beams.

According to a specific embodiment of the invention, the support structure comprises at least a first plurality of circumferentially oriented beams and a second plurality of axially oriented beams.

The at least one sensor may be attached to any of the flat bars and/or any of the circumferentially oriented beams and/or any of the axially oriented beams and/or the lamination stack.

According to embodiments of the invention, the at least one sensor is an accelerometer or a strain gauge or a microphone or a laser or an optic sensor.

According to a second aspect of the present invention it is provided a method of monitoring the at least one weld in the stator according to the present invention, the method comprising the steps of:
- collecting signals from the at least one sensor,
- extracting relevant features from the signals collected from the at least one sensor, said features indicating the presence of structural damage.

Filtering of the signals collected from the at least one sensor may be optionally foreseen.

According to embodiments of the invention, relevant feature may include changes in frequency or amplitude of peaks in a frequency or order spectrum, in particular to be compared with critical structural frequencies of the stator and/or harmonics of the electrical frequency of the generator at designed operating points.

In all its aspects, this invention fulfill the above defined purpose, by providing an efficient monitoring system and method for monitoring the welds in the stator, particularly the welds used for fixing the lamination stacks to the respective support structure. The system and method of the present inventions achieves a greater versatility with respect to the existing prior art.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawing

- Figure 1: shows a schematic section of a wind turbine including an electrical generator with a stator according to the present invention.
- Figure 2: shows an exploded view of an electrical generator with a stator according to the present invention.
- Figure 3: shows an axonometric view of a segment of the stator of Fig. 2.
- Figure 4: shows an exploded view of the segment of Fig. 3.
- Figure 5: shows a schematic partial view an electrical generator with a stator according to the present invention, the view being orthogonal to the rotational axis of the electrical generator.
- Figure 6: shows a partial view of the stator of Fig. 5, viewed along the view direction VI of Fig. 5.

### Detailed Description

The illustrations in the drawings are schematic. It is noted that in different figures, similar or identical elements are provided with the same reference signs.

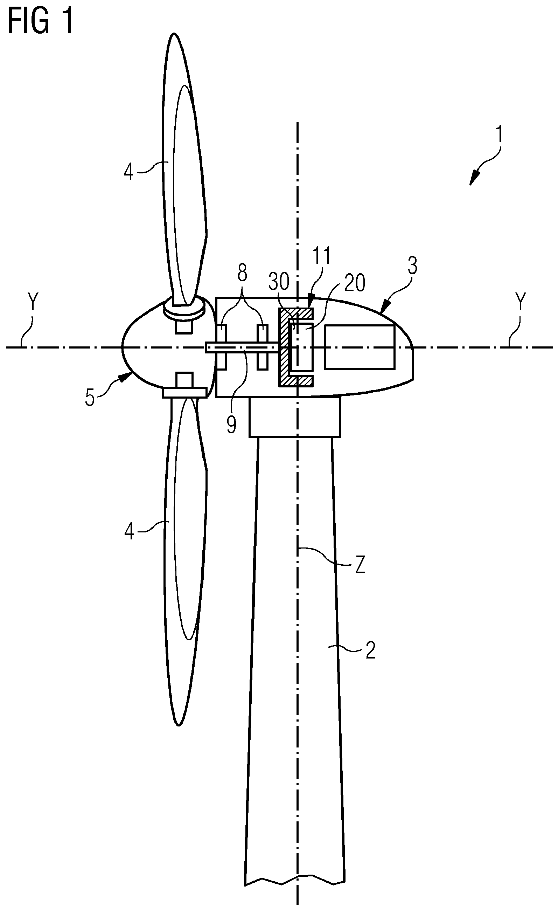

**Figure 1** shows a wind turbine 1 according to the invention. The wind turbine 1 comprises a tower 2, which is mounted on a non-depicted foundation. A nacelle 3 is arranged on top of the tower 2.

The wind turbine 1 further comprises at least a wind rotor 5 having a hub and at least one blade 4 (in the embodiment of Figure 1, the wind rotor comprises three blades 4, of which only two blades 4 are visible). The wind rotor 5 is rotatable around a rotational axis Y.

The blades 4 extend substantially radially with respect to the rotational axis Y.

In general, when not differently specified, the terms axial, radial and circumferential in the following are made with reference to the rotational axis Y.

The wind turbine 1 comprises at least one electric generator 11, including a stator 20 and a rotor 30. The rotor 30 is rotatable with respect to the stator 20 about the rotational axis Y.

The wind rotor 5 is rotationally coupled with the electric generator 11 by means of a rotatable main shaft 9 and/or through a gear box (not shown in Figure 1). A schematically depicted bearing assembly 8 is provided in order to hold in place the main shaft 9 and the rotor 5. The rotatable main shaft 9 extends along the rotational axis Y.

According to another embodiment of the present invention, the wind rotor 5 is rotationally coupled with the electric generator 11 (direct drive generator).

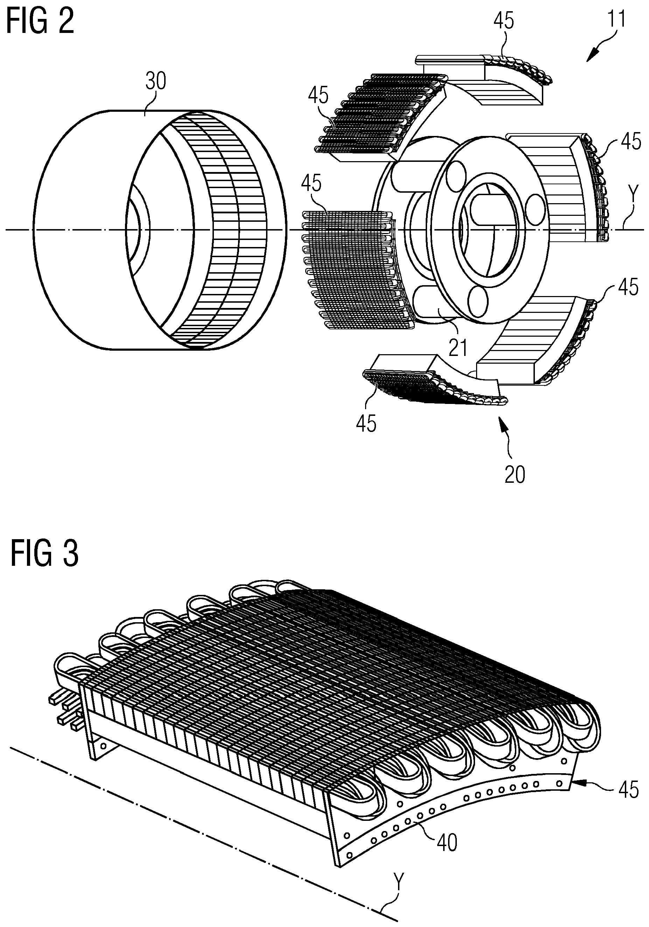

**Figure 2** shows an exploded view of the electrical generator 11 with the rotor 30 and the stator 20.

The stator 20 comprises a cylindrical inner core 21 to which six segments 45 are attached. Each segment 45 has a circumferential angular extension of 60°.

According to other embodiments of the present invention, the stator 20 comprises a plurality of segments having a number of segments different from six.

According to another possible embodiment of the present invention, the stator 20 is not segmented, i.e. the stator includes one single segment covering the entire angular extension of 360°.

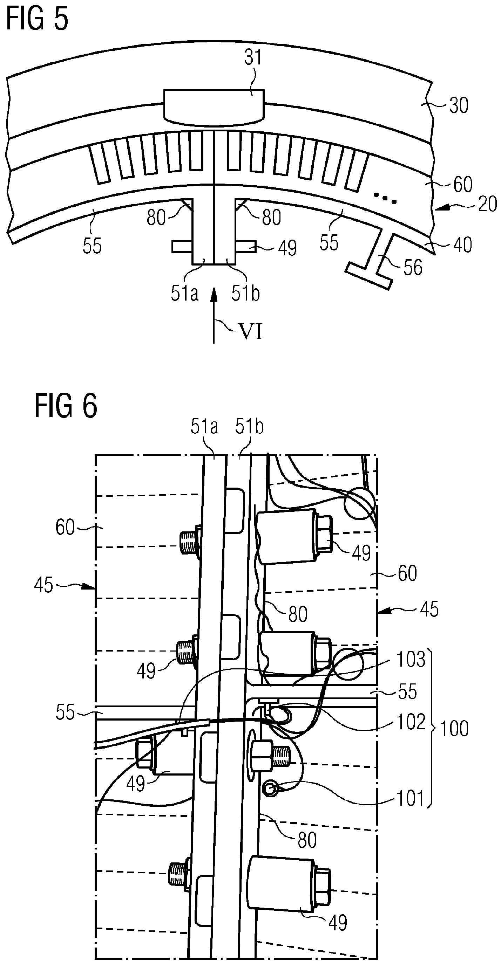

The stator 30 has a conventional structure with a plurality of circumferentially distributed stator permanent magnets 31 (as better shown in Figure 5).

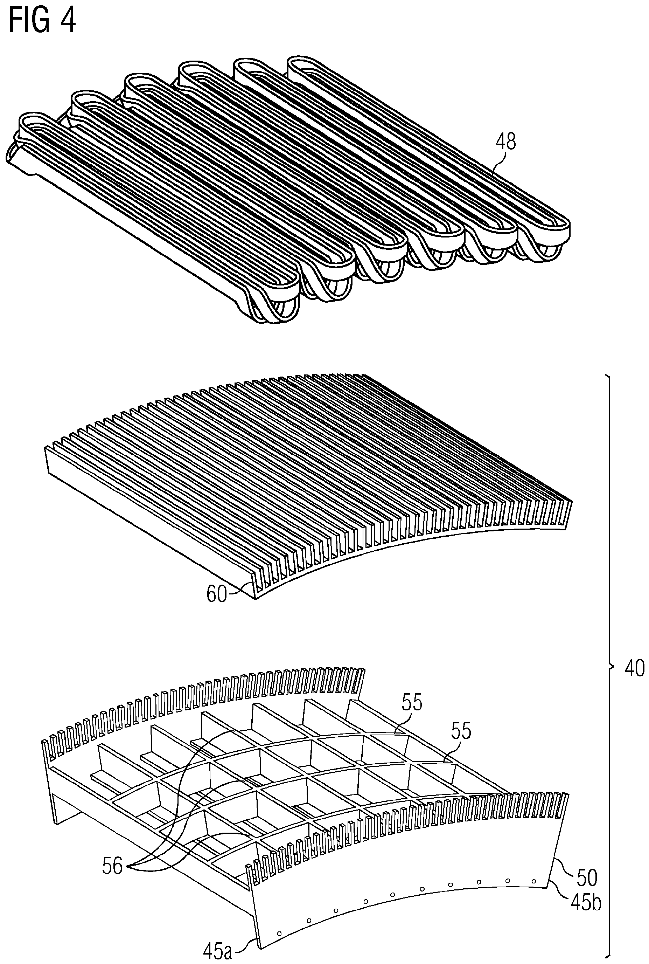

**Figures 3** and **4** show more in details a stator segment 45. The stator segment 45 has a conventional structure comprising a plurality of teeth circumferentially interposed between a plurality of slots. The teeth protrude according to the radial direction. The stator segment 45 further comprises coil windings 48 inserted in the slots of the segment 45.

Teeth, slots and windings 48 are not a specific object of the present invention and therefore not described in further details.

Each segment 45 includes a support structure 50 and a lamination stack 60 supported by the support structure 50.

The support structure 50 circumferentially extends between two circumferential ends 45a, 45b. At each circumferential end 45a, 45b a respective flat bar 51a, 51b is provided for joining together the plurality of segments 45, by means of a plurality of bolted connections 49.

The lamination stack 60 comprises a plurality of lamination sheets which are attached one after another along the axial direction of the stator 20.

The lamination stack 60 is welded to the support structure 50 as better specified in the following.

When the stator segments 45 are joined together by means of the bolted connections 49 between the respective flat bars 51a, 51b, the assembly made by all the support structures 50 and the lamination stack 60 constitutes a stator body 40.

According to the possible embodiment of the present invention where the stator 20 is not segmented, the stator body 40 is made of a single support structure 50 and a single lamination stack 60, both covering the entire angular extension of 360°. In the latter embodiment the flat bars 51a, 51b are not present.

The stator body 40 comprises at least one welding 80 to be monitored to a monitoring device 100 (Fig. 6).

The support structure 50 of each stator segment comprises a first plurality of circumferentially oriented beams 55 and a second plurality axially oriented beams 56.

According to other embodiment of the present invention, the support structure of each stator segment comprises only axially oriented beams 56.

The circumferentially oriented beams 55 extends from one to the other of the flat bars 51a, 51b and the axially oriented beams 56 are parallel to the flat bars 51a, 51b, thus creating a net pattern of the support structure.

According to other embodiments of the present invention, the support structure 50 may include another plurality of differently oriented beams and/or one or more plates attached together by welds or bolts or any binding technique.

The lamination stack 60 is fixed to the support structure 50 by means of a plurality of welds 80.

**Figure 5** shows that the plurality of welds 80 is provided between the lamination stack 60 and the flat bars 51a, 51b.

According to possible embodiment of the present invention, the plurality of welds 80 may be also provided between the lamination stack 60 and the second plurality of axially oriented beams 56.

According to other possible embodiment of the present invention, the plurality of welds 80 may be also or alternatively provided between the lamination stack 60 and the first plurality of circumferentially oriented beams 55 and/or the axially oriented beams 56.

According to the possible embodiment of the present invention where the stator 20 is not segmented, the plurality of welds 80 are provided on the second plurality of axially oriented beams 56 and/or first plurality of circumferentially oriented beams 55.

**Figure 6** shows the monitoring device 100 for monitoring the welds 80 between the lamination stack 60 and the flat bars 51a, 51b. The monitoring device 100 comprising three acceleration sensors 101, 102, 103, respectively attached to the lamination stack 60, to one circumferentially oriented beam 55 (belonging to a first stator segment 45) and to another circumferentially oriented beam 55 (belonging to a second stator segment 45). All acceleration sensors 101, 102, 103 are placed closed to the welds 80 to be monitored.

Each of the sensors 101, 102, 103 may be attached to any of the flat bars 51a, 51b and/or of the first plurality of 55 and/or of the second plurality axially oriented beams 56.

According to other embodiments of the present invention any sensor may be used, which is capable of measuring, directly or indirectly, the dynamic deformation of the structure of the stator body 40 in proximity of the welds 80.

Sensors which may be conveniently placed in proximity of the welds, for measuring the dynamic deformation of the structure of the stator body 40, are accelerometers and strain gauges.

According to other embodiments of the present invention, laser sensors or optic sensors are used for measuring the dynamic deformation of the structure of the stator body 40 in proximity of the welds 80.

Microphones may be also placed inside the stator for detecting noises, which are correlated to damages, for example a crack, in the welds 80.

According to the different embodiments of the present invention any number of sensors may be used.

A method of monitoring the welds 80 in the stator 20 according to the present invention comprises the steps of:
- collecting signals from the sensors 101, 102, 103,
- extracting relevant features from the signals.

The features are chosen in such a way that they are able to indicate the presence of structural damage.

Optionally, after the step of collecting the signals, a step of filtering such signals may be performed.

For example a frequency or order spectrum of the signals may be extracted, whose peaks or relevant changes may be compared with the critical structural frequencies of the stator body 40.

Peaks may be also compared to harmonics of the electrical frequency of the generator at designed operating points.

## Claims

1. Stator (20) for an electrical generator (11) including a stator body (40) comprising:
- a support structure (50),
- a lamination stack (60) supported by the support structure (50),
- at least one welding (80),
wherein the stator body (40) further comprised a monitoring device (100) for monitoring the at least one welding (80), the monitoring device (100) comprising at least one sensor (101, 102, 103) for measuring the dynamic deformation of the stator body (40).

2. Stator (20) as claimed in claim 1, wherein the lamination stack (60) is fixed to the support structure (50) by means of said at least one weld (80).

3. Stator (20) as claimed in claim 1 or 2, wherein the stator (20) comprises a plurality of segments (45) joined together at respective circumferential ends (45a, 45b), said at least one welding (80) being provided at one respective circumferential end (45a, 45b).

4. Stator (20) as claimed in claim 3, wherein for each segment (45) the support structure (50) comprises two flat bars (51a, 51b) at the respective circumferential ends (45a, 45b) for joining together the plurality of segments (45), said at least one welding (80) being provided at one or both the flat bars (51a, 51b).

5. Stator (20) as claimed in any of the claims 1 to 4, wherein the support structure (50) comprises at least a plurality of axially oriented beams (56).

6. Stator (20) as claimed in claim 4 or 5, wherein the at least one sensor (101, 102, 103) is attached to any of the flat bars (51a, 51b) and/or of the first plurality of circumferentially oriented beams (55) and/or of the second plurality axially oriented beams (56).

7. Stator (20) as claimed in any of the claims 1 to 6, wherein the at least one sensor (101, 102, 103) is attached to the lamination stack (60).

8. Stator (20) as claimed in any of the claims 1 to 6, wherein the at least one sensor (101, 102, 103) is an accelerometer or a strain gauge or a microphone or a laser or an optic sensor.

9. Electrical generator (11) for a wind turbine (1) including at least a stator (20) as claimed in any of the claims 1 to 8.

10. Wind turbine (1) including at least one electrical generator (11) of claim 9.

11. Method of monitoring the at least one welding (80) in the stator (20) as claimed in any of the claims 1 to 8, the method comprising the steps of:
- collecting signals from the at least one sensor (101, 102, 103),
- extracting relevant features from the signals collected from the at least one sensor (101, 102, 103), said features indicating the presence of structural damage.

12. Method as claimed in claim 11, the method comprising the steps of:
- filtering the signals collected from the at least one sensor (101, 102, 103) after the step of collecting the signals.

13. Method as claimed in claim 11 or 12, wherein relevant feature include changes in a frequency or order spectrum.
